# FASCICULE DE BREVET EUROPEEN

(11) **EP 0 991 190 B1**
(45) Date de publication et mention de la délivrance du brevet: **02.02.2005**
(21) Numéro de dépôt: 99117333.7
(22) Date de dépôt: 03.09.1999
(51) Int. Cl.: H03K 17/97

(54) **Commutateur sans contact pour ensemble haut de colonne de direction de véhicule automobile**
Berührungsloser Schalter für Lenksäulen von Kraftfahrzeugen
Contactless switch for motor vehicle steering column

(30) Priorité: 01.10.1998 FR 9812284
(43) Date de publication de la demande: 05.04.2000
(73) Titulaire: Valeo Electronique, 94042 Créteil (FR)
(72) Inventeur: Huynh, Tan Duc, 93330 Neuilly-Sur-Marne (FR); Le Toumelin, Rémi, 77400 Lagny (FR)
(74) Mandataire: Croonenbroek, Thomas

(56) Documents cités:
- EP-A- 0 791 505
- DE-A- 3 213 151
- US-A- 3 818 154
- US-A- 4 216 458

## Description

L'invention concerne un commutateur pour ensemble de commutation de haut de colonne de direction de véhicule automobile, comprenant un boîtier renfermant les mécanismes de commutation et d'indexage, et une manette de commande susceptible de pivoter dans un plan de pivotement sensiblement parallèle au volant et de basculer dans un plan de basculement perpendiculaire au plan de pivotement et contenant l'axe de ladite manette, les mécanismes de commutation commutant des faibles courants interprétés par une carte électronique embarquée.

Dans les commutateurs à faibles courants, la commutation est généralement réalisée par des contacts électriques établis entre un doigt frotteur d'un mécanisme de commutation et des pistes conductrices d'un circuit imprimé. Une carte électronique embarquée interprète les signaux et communique les commandes aux divers modules du véhicule.

Cette disposition nécessite l'utilisation d'un circuit imprimé ou surmoulé, qui entraîne des coûts. De plus, il y a des problèmes d'efforts mécaniques et des frottement au droit des contacts qui entraînent une usure dans le temps.

L'invention s'est donné pour but de pallier ces inconvénients, en supprimant les contacts.

Le document US-A-4 216 458 divulgue un commutateur sans contacts.

Selon l'invention, le commutateur proposé est caractérisé par le fait que les mécanismes de commutation comportent un aimant permanent monté mobile en translation par rapport au boîtier, des moyens pour transformer les mouvements de pivotement et de basculement de la manette de commande en un mouvement de translation de l'aimant, afin que ledit aimant ait une position prédéterminée pour chaque position d'indexage de la manette de commande, et un capteur magnétique à effet Hall fixe par rapport au boîtier et apte a fournir à la carte électronique une tension dont la valeur est fonction de la position de l'aimant.

Avantageusement, l'aimant est porté par une plaque de support disposée perpendiculairement au plan de pivotement et au plan de basculement et montée mobile parallèlement au plan de pivotement, et les moyens pour transformer les mouvements de pivotement et de basculement de la manette en un mouvement de translation de l'aimant comportent une entretoise solidaire du corps de la manette de commande dont l'extrémité coopère avec une rainure ménagée dans ladite plaque de support, obliquement par rapport aux plans de pivotement et de basculement.

D'autres avantages et caractéristiques de l'invention ressortiront à la lecture de la description suivante faite à titre d'exemple et en référence aux dessins annexés dans lesquels :

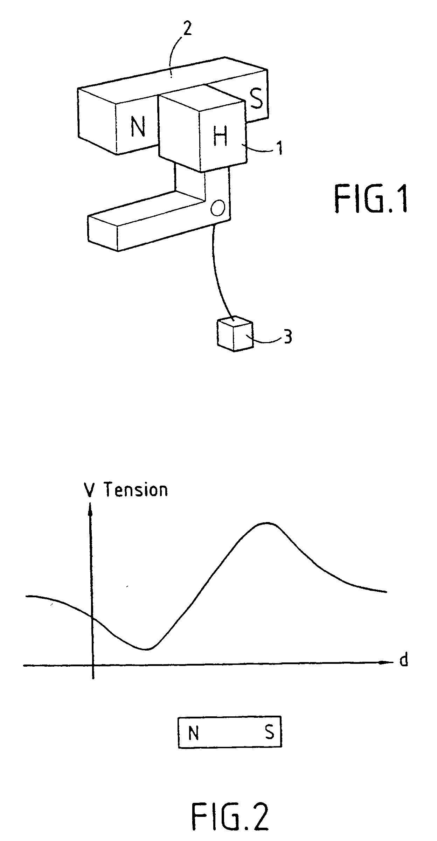

la figure 1 montre le principe appliqué dans les mécanismes de commutation selon la présente invention ;
la figure 2 montre la tension relevée aux bornes du capteur magnétique à effet Hall en fonction du déplacement relatif du capteur entre les pôles de l'aimant ;
la figure 3 montre un exemple de l'évolution de la tension de commande en fonction des positions d'indexage de la manette de commande d'un commutateur d'éclairage ;
la figure 4 montre un exemple de l'évolution de la tension de commande en fonction de la position d'indexage de la manette de commande d'un commutateur d'essuyage ;
la figure 5 montre schématiquement un commutateur et les moyens pour transformer les mouvements de pivotement et de basculement de la manette de commande en un mouvement de translation de l'aimant permanent ;
les figures 6 et 7 montrent des variantes de réalisation du commutateur de la figure 5.

Selon les dessins on a représenté par la référence 1 un capteur magnétique à effet Hall ou magnéto-résistance et par la référence 2 un aimant permanent disposé au voisinage du capteur 1.

Il est connu qu'un capteur à effet Hall développe une tension linéaire V en fonction de l'éloignement E aux pôles Nord-Sud d'un aimant permanent. Cette tension appliquée aux bornes d'un connecteur 3 peut être utilisée pour mesurer la position de l'aimant 2 par rapport au capteur 1, au moyen d'une carte électronique.

L'invention utilise ce principe dans un commutateur de commutation de haut de colonne de direction de véhicule automobile pour éliminer les contacts électriques des commutateurs traditionnels.

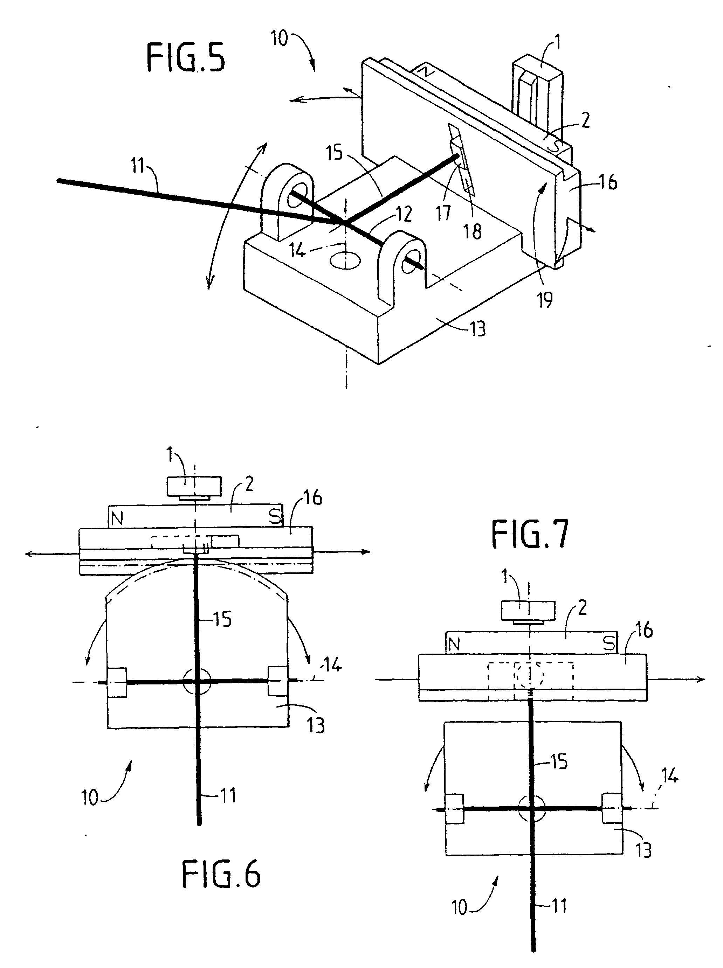

La figure 5 montre schématiquement un commutateur 10 pour véhicule qui comporte une manette de commande 11 montée basculante autour d'un axe de basculement 12 parallèle au plan du volant sur un moyeu 13 lui-même monté pivotant autour d'un axe de pivotement 14 perpendiculaire au plan du volant sur un boîtier fixe par rapport au véhicule et non représenté sur le dessin.

La manette de commande 11 se prolonge à l'intérieur du boîtier par une entretoise 15. Cette entretoise 15 peut prendre plusieurs positions stables ou instables par actionnement de la manette de commande 11 autour de l'axe de pivotement 14 ou autour de l'axe de basculement 12, grâce à des mécanismes d'indexage connus en soi et non montrés sur les dessins.

Un capteur magnétique à effet Hall 1 est fixé sur le boîtier du commutateur 10. Un aimant permanent 2 est porté par une plaque de support 16, parallèlement à l'axe de basculement 12. L'aimant permanent 2 est disposé au voisinage immédiat du capteur 1.

Selon le mode de réalisation montré sur la figure 5, la plaque de support 16 est montée coulissante sur le moyeu 13. Selon des variantes de réalisation montrées sur les figures 6 et 7, la plaque de support 16 est montée coulissante sur le boîtier du commutateur 10.

L'extrémité de l'entretoise 15 porte un galet 17 qui est susceptible de coulisser dans une rainure 18 ménagée sur la face 19 de la plaque de support 16 qui est en vis-à-vis de l'entretoise 15. La rainure 18 est disposée obliquement par rapport aux plans perpendiculaires à l'axe de basculement 12 et à l'axe de pivotement 14.

On conçoit clairement que lorsqu'on fait pivoter la manette de commande 11 autour de l'axe de pivotement 14, l'entretoise 15 pivote également autour de l'axe de pivotement 14 et entraîne un déplacement de l'ensemble constitué par la plaque de support 16 et par l'aimant permanent 2 par rapport au boîtier du commutateur 10, entraînant par le fait même un changement de tension aux bornes de connecteur 3. Lorsque la plaque de support 16 est portée par le moyeu 13, la plaque de support 16 reste immobile par rapport au moyeu 13, lors du pivotement de la manette de commande 11 autour de l'axe de pivotement 14. Il est à noter que le galet 17 reste immobile dans la rainure 18, lors du pivotement de la manette de commande autour de l'axe de pivotement 14.

Dans la position neutre de la manette de commande 11, le capteur 1 est sensiblement situé à égale distance des pôles Nord et Sud de l'aimant 2. Dans les positions extrêmes de la manette de commande 11 par pivotement autour de l'axe 14, le capteur 1 est au voisinage des pôles Nord et Sud de l'aimant 2.

Lorsqu'on fait pivoter la manette de commande 11 autour de l'axe de basculement 12, dans le sens tirer/pousser, l'entretoise 15 pivote autour de l'axe 12, et le galet 17 coulisse dans la rainure 18, entraînant par le fait même une translation de la plaque de support 16 et de l'aimant 2 par rapport au boîtier du commutateur 10. Lorsque la plaque de support 16 est portée par le moyeu 13, la plaque de support 16 est déplacée par coulissement sur le moyeu 13.

L'inclinaison de la rainure 18 est calculée de telle manière que le déplacement de l'aimant 2 par basculement de la manette de commande 11 entre deux positions d'indexage dans le sens tirer/pousser est plus faible que le déplacement de l'aimant 2 par pivotement de la manette de commande 11 autour de l'axe de pivotement entre deux positions d'indexage.

Chaque position d'indexage se traduit donc par un positionnement prédéterminé de l'aimant 2 par rapport au boîtier et au capteur 1, et par une valeur de la tension aux bornes du connecteur 3, représentative de cette position. Cette valeur de tension analysée et traitée par une électronique embarquée à bord du véhicule équipé du commutateur décrit ci-dessus, permet à cette électronique de réaliser les fonctions affichées par la manette 10.

Ce qui compte, c'est qu'il y ait une correspondance biunivoque entre les positions d'indexation de la manette de commande 11 et les positions de l'aimant 2.

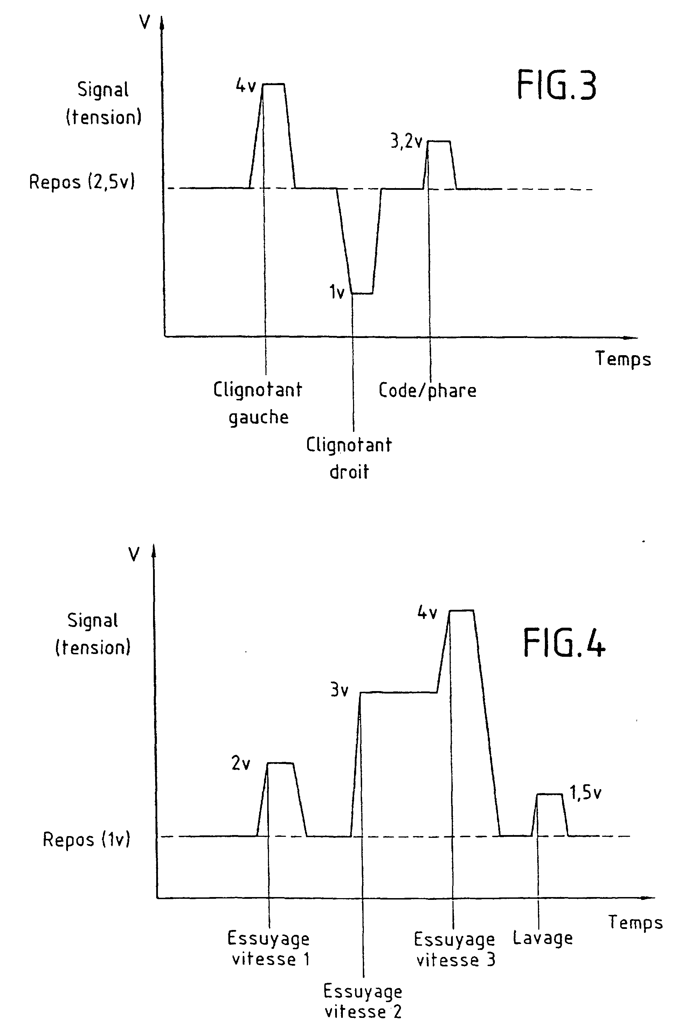

La figure 3 montre à titre d'exemple la tension appliquée aux bornes du connecteur 3 dans différentes positions de la manette de commande 11 d'un commutateur d'éclairage. Dans la position médiane de la manette de commande 11, la tension est de 2,5 V. Dans la position clignotant à gauche, la tension s'élève à 4V et dans la position clignotant à droite, la tension descend à 1 V. Si en partant de ces positions, ou bascule la manette de commande 11 autour de l'axe de basculement 12, dans le sens tirer pousser, la tension subit une variation de 0,7 V par exemple. Ainsi, si on tire la manette de commande 11 à partir de la position médiane, pour établir la fonction code/phase, la tension est de 3,2 V.

La figure 4 montre à titre d'exemple les tensions appliquées aux bornes du connecteur 3 dans différentes positions de la manette de commande 11 d'un commutateur d'essuyage. La tension relevée dans la position de repos est, par exemple, de 1 V. Lorsqu'on pivote la manette de commande autour de l'axe de pivotement 14, pour obtenir différentes vitesses d'essuyage, la tension est de 2 V à faible vitesse, de 3 V à la vitesse moyenne et de 4 V à grande vitesse. Lorsqu'on bascule la manette de commande 11 autour de l'axe de basculement 12, la tension subit une variation de 0,5 V. Ainsi, la tension est de 1,5V lorsqu'on exécute la fonction de lavage en partant de la position de repos.

## Revendications

1. Commutateur pour ensemble de commutation de haut de colonne de direction de véhicule automobile, comprenant un boîtier renfermant les mécanismes de commutation et d'indexage, et une manette de commande (11) susceptible de pivoter dans un plan de pivotement sensiblement parallèle au volant et de basculer dans un plan de basculement perpendiculaire au plan de pivotement et contenant l'axe de ladite manette (11), les mécanismes de commutation commutant des faibles courants interprétés par une carte électronique embarquée **caractérisé par le fait que** les mécanismes de commutation comportent un aimant permanent (2) monté mobile en translation par rapport au boîtier, des moyens pour transformer les mouvements de pivotement et de basculement de la manette de commande (11) en un mouvement de translation de l'aimant (2), afin que ledit aimant (2) ait une position prédéterminée pour chaque position d'indexage de la manette de commande (11), et un capteur magnétique (1) à effet Hall fixe par rapport au boîtier et apte à fournir à la carte électronique une tension dont la valeur est fonction de la position de l'aimant (2).

2. Commutateur selon la revendication 1, **caractérisé par le fait que** l'aimant (2) est porté par une plaque de support (16) disposée perpendiculairement au plan de pivotement et au plan de basculement et montée mobile parallèlement au plan de pivotement, et **par le fait que** les moyens pour transformer les mouvements de pivotement et de basculement de la manette de commande (11) en un mouvement de translation de l'aimant (2) comportent une entretoise (15) solidaire du corps de la manette de commande (11) dont l'extrémité coopère avec une rainure (18) ménagée dans ladite plaque de support (16), obliquement par rapport aux plans de pivotement et de basculement.

3. Commutateur selon la revendication 2, **caractérisé par le fait que** la plaque de support (16) est montée coulissante dans le boîtier.

4. Commutateur selon la revendication 2, **caractérisé par le fait que** la manette de commande (11) est montée pivotante autour d'un axe de basculement (12) sur un moyeu (13) lui-même monté pivotant dans le boîtier autour d'un axe de pivotement (14) perpendiculaire à l'axe de basculement (12) et **par le fait que** la plaque de support (16) est montée coulissante sur le moyeu (13).

5. Commutateur selon l'une quelconque des revendications 1 à 4, **caractérisé par le fait que** ledit commutateur est un commutateur d'éclairage.

6. Commutateur selon l'une quelconque des revendications 1 à 4, **caractérisé par le fait que** ledit commutateur est un commutateur d'essuyage.

## Patentansprüche

1. Schalter für eine Schalteinrichtung im oberen Bereich der Lenksäule von Kraftfahrzeugen, mit einem Gehäuse, das Schalt- und Indexierungsmechanismen umschließt, und einer Steuerhandhabe (11), die in einer im wesentlichen parallel zum Lenkrad verlaufenden Schwenkebene verschwenkbar und in einer zur Schwenkebene senkrecht verlaufenden Kippebene kippbar ist und die Achse der genannten Handhabe (11) enthält, wobei die Schaltmechanismen geringe Ströme durchschalten, die von einer an Bord mitgeführten elektronischen Karte ausgewertet werden, **dadurch gekennzeichnet, dass** die Schaltmechanismen einen Dauermagneten (2) aufweisen, der gegenüber dem Gehäuse translatorisch verschiebbar gelagert ist, sowie Mittel zum Umwandeln der Schwenk- und Kippbewegungen der Steuerhandhabe (11) in eine Verschiebebewegung des Magneten (2), damit der Magnet (2) eine vorbestimmte Stellung bei jeder Indexierungsstellung der Steuerhandhabe (11) einnimmt, und einen gegenüber dem Gehäuse feststehenden Magnetsensor (1) mit Halleffekt, welcher der elektronischen Karte eine Spannung liefern kann, deren Wert eine Funktion von der Stellung des Magneten (2) ist.

2. Schalter nach Anspruch 1, **dadurch gekennzeichnet, dass** der Magnet (2) von einer Tragplatte (16) getragen wird, die senkrecht zur Schwenkebene und zur Kippebene angeordnet und parallel zur Schwenkebene verstellbar montiert ist, und dass die Mittel zum Umwandeln der Schwenk- und Kippbewegungen der Steuerhandhabe (11) in eine Verschiebebewegung des Magneten (2) eine Strebe (15) enthalten, die fest mit dem Körper der Steuerhandhabe (11) verbunden ist und deren Ende mit einer Nut (18) zusammenwirkt, die in der Tragplatte (16) schräg zu der Schwenk- und Kippebene ausgeführt ist.

3. Schalter nach Anspruch 2, **dadurch gekennzeichnet, dass** die Tragplatte (16) im Gehäuse gleitbeweglich montiert ist.

4. Schalter nach Anspruch 2, **dadurch gekennzeichnet, dass** die Steuerhandhabe (11) um eine Kippachse (12) verschwenkbar an einer Nabe (13) montiert ist, die ihrerseits in dem Gehäuse um eine Schwenkachse (14) verschwenkbar montiert ist, welche senkrecht zur Kippachse (12) verläuft, und dass die Tragplatte (16) an der Nabe (13) gleitbeweglich montiert ist.

5. Schalter nach einem der Ansprüche 1 bis 4, **dadurch gekennzeichnet, dass** der Schalter ein Lichtschalter ist.

6. Schalter nach einem der Ansprüche 1 bis 4, **dadurch gekennzeichnet, dass** der Schalter ein Schalter für Scheibenwischer ist.

## Claims

1. A switch for a switching unit for the top of a motor vehicle steering column, comprising a housing which encloses the switching and indexing mechanisms, and a control stalk (11) adapted for pivoting movement in a pivot plane which is substantially parallel to the steering wheel, and for tilting movement in a tilting plane which is at right angles to the pivot plane and which contains the axis of the said stalk (11), the switching mechanisms switching low currents which are interpreted by an on-board electronic printed circuit, **characterised by** the fact that the switching mechanisms include a permanent magnet (2) which is mounted for straight-line movement with respect to the housing, means for converting the pivoting and tilting movements of the control stalk (11) into a movement of the magnet (2) in a straight line, whereby the said magnet (2) has a predetermined position for each indexing position of the control stalk (11), and a Hall effect sensor (1), fixed with respect to the housing and adapted to supply the electronic printed circuit with a voltage the value of which is a function of the position of the magnet (2).

2. A switch according to Claim 1, **characterised by** the fact that the magnet (2) is carried by a support plate (16) disposed at right angles to the pivot plane and at right angles to the tilting plane, and mounted for movement parallel to the pivot plane, and by the fact that the means for converting the pivoting and tilting movements of the control stalk (11) into a movement of the magnet (2) in a straight line comprise a spacer (15) which is fixed with respect to the body of the control stalk (11), and the end of which is in cooperation with a groove (18) formed in the said support plate (16), obliquely with respect to the pivoting and tilting planes.

3. A switch according to Claim 2, **characterised by** the fact that the support plate (16) is mounted for sliding movement in the housing.

4. A switch according to Claim 2, **characterised by** the fact that the control stalk (11) is mounted for pivoting movement about a tilt axis (12) on a hub (13), which is itself mounted for pivoting movement in the housing about a pivot axis (14) at right angles to the tilt axis (12), and by the fact that the support plate (16) is mounted for sliding movement on the hub (13).

5. A switch according to any one of Claims 1 to 4, **characterised by** the fact that the said switch is a lighting switch.

6. A switch according to any one of Claims 1 to 4, **characterised by** the fact that the said switch is a wiping switch.
